(19) European Patent Office
Europäisches Patentamt
Office européen des brevets

(11) EP 1 078 717 A2

(12) EUROPEAN PATENT APPLICATION

(43) Date of publication:
28.02.2001 Bulletin 2001/09

(51) Int. Cl.⁷: **B24D 3/34**

(21) Application number: 00116703.0

(22) Date of filing: 02.08.2000

(84) Designated Contracting States:
**AT BE CH CY DE DK ES FI FR GB GR IE IT LI LU MC NL PT SE**
Designated Extension States:
**AL LT LV MK RO SI**

(30) Priority: 02.08.1999 JP 21925599
19.07.2000 JP 2000219670

(71) Applicant: EBARA CORPORATION
Ohta-ku, Tokyo (JP)

(72) Inventors:
• **Hirokawa, Kazuto**
  **Chigasaki-shi, Kanagawa-ken (JP)**

• **Hiyama, Hirokuni**
  **Tokyo (JP)**
• **Wada, Yutaka**
  **Chigasaki-shi, Kanagawa-ken (JP)**
• **Matsuo, Hisanori**
  **Fujisawa-shi, Kanagawa-ken (JP)**

(74) Representative:
**Geyer, Ulrich F., Dr. Dipl.-Phys. et al**
**WAGNER & GEYER,**
**Patentanwälte,**
**Gewürzmühlstrasse 5**
**80538 München (DE)**

(54) **Fixed abrasive polishing tool**

(57)     An abrading plate for polishing comprises abrasive particles, a chemical, and a binder for binding the abrasive particles and the chemical together. The abrasive particles are preferably abrasive particle aggregates. The chemical may be enclosed in capsules, and fixed in the abrading plate. The abrading plate for polishing can satisfactorily show stability of a polishing speed, step characteristics, and self-stop function for various objects to be polished.

*F I G. 1*

**Description**

BACKGROUND OF THE INVENTION

Field of the Invention:

This invention relates to a fixed abrasive polishing tool (hereinafter "an abrading plate") for polishing, and more particularly, to an abrading plate for polishing an object to be polished, such as a semiconductor wafer, in a flat and mirror-like state.

Description of the Related Art:

In recent years, with the increased integration of semiconductor devices, the line width of circuit interconnection has become narrower, and the device size to be integrated therein has become finer. This may require the step of removing a film formed on the surface of a semiconductor wafer by polishing to flatten the surface thereof. As means of this surface flattening or planarization, polishing by means of a chemical and mechanical polishing (CMP) device is performed. This type of CMP device has a turntable provided with an abrasive cloth (pad) thereon, and a top ring. An object to be polished is interposed between the turntable and the top ring. With the turn table being kept under a constant pressure from the top ring, and the abrasive cloth being supplied with a polishing liquid (slurry), the turn table and the top ring rotate to polish the surface of the object to be polished into a flat, mirror-like form.

The above-described CMP process performs polishing while supplying a polishing liquid (slurry) containing a large amount of abrasive particles to a relatively soft abrasive cloth. Thus, this process is problematical in terms of pattern dependency. Pattern dependency refers to the fact that an irregular pattern on the semiconductor wafer, which has existed before polishing, results in the formation of mild irregularities after polishing, thus making it difficult to obtain perfect flatness. That is, irregularities with small pitches lead to a high polishing speed, while irregularities with large pitches lead to a low polishing speed, with the result that the fast polishing portions and the slow polishing portions together result in the formation of the mild irregularities. Besides, the polishing process using the abrasive cloth (pad) polishes both the projections and the depressions of the irregularities, thus posing difficulty in achieving a so-called self-stop function, i.e., the function that only the projections are polished away to bring complete flatness, and at this time, polishing is terminated.

On the other hand, study is under way about polishing of a semiconductor wafer using so-called fixed abrasive particles (an abrading plate), i.e., abrasive particles, such as cerium oxide ($CeO_2$), fixed with the use of a binder, such as phenol resin. Polishing with such an abrading plate is advantageous in the following respects: The abrasive surface is hard unlike that in conventional CMP. Thus, the projections of the irregularities are polished preferentially, while the depressions of the irregularities are polished with difficulty, so that absolute flatness is easy to obtain. Depending on the composition of the abrading plate, moreover, the self-stop function emerges in the following manner: Polishing of the projections is completed to impart a flat surface. At this time, the polishing speed markedly lowers, and polishing actually does not proceed any more. In addition, polishing with an abrading plate does not use a polishing liquid (slurry) containing a large amount of abrasive particles, thus conferring the advantage that the burden of an environmental problem is lessened.

Polishing by using an abrading plate, however, poses the following problems: If the composition of the abrading plate is such that the binding force of a binder for binding abrasive particles is high, the abrasive particles minimally exhibit a self-producing effect during polishing. Immediately after dressing, a relatively high polishing speed is obtained. However, as polishing proceeds, the polishing speed decreases, failing to obtain a sufficient polishing speed. In the case of an abrading plate with a low binding force of a binder for binding abrasive particles, the abrading plate is brittle as a whole. Since the abrasive particles easily self-produce, a relatively high polishing speed is obtained. However, not only the projections, but also the depressions of the irregularities of the surface of workpiece are also polished. After polishing, a completely flat surface is difficult to obtain, arousing a problem with so-called step characteristics. In addition, such an abrading plate minimally achieves the self-stop function that progress of polishing automatically stops after polishing of only the projections is completed.

Hence, an abrading plate showing the self-stop function is in a relatively narrow range in which the proportions of a binder, abrasive particles, and pores are well balanced. Such an abrading plate does not necessarily provide the desired polishing speed stability and step characteristics for the object to be polished. Materials to be polished range widely, including silicon substrates, polysilicon films, oxide films, nitride films, and interconnection layers comprising aluminum or copper materials. Producing abrading plates, which have stability of polishing speed, satisfactory step characteristics, and self-stop function, in response to these various objects to be polished have been virtually difficult.

## SUMMARY OF THE INVENTION

The present invention has been accomplished in light of the foregoing circumstances. Its object is to provide an abrading plate for polishing which can satisfactorily exhibit stability of a polishing speed, step characteristics, and a self-stop function for various objects to be polished.

A first aspect of the invention is a fixed abrasive polishing tool (abrading plate) comprising abrasive particles, a chemical, and a binder for binding the abrasive particles and the chemical together. Since the abrading plate is composed of the abrasive particles, the chemical and the binder, the chemical can be supplied during polishing from the abrading plate itself to a surface of the object to be polished. Supplying a surface-active agent as the chemical, for example, makes it possible to exhibit the self-stop function that once the projections of the irregularities are polished away and the surface is flattened, progress of polishing automatically stops. Alternatively, an oxidizing agent or a reducing agent is incorporated as the chemical into the abrading plate, whereby a solution of the chemical is supplied to the surface to be polished, as in chemical and mechanical polishing with a polishing liquid, so that chemical polishing can be carried out. The use of such an abrading plate, coupled with the mere supply of pure water necessary as a coolant and a lubricant, enables chemical and mechanical polishing to be performed for various objects to be polished.

The abrasive particles may form abrasive particle aggregates. Since lumpy aggregates of fine abrasive particles formed by gathering many fine abrasive particles adapted for micro fabrication of a semiconductor device and binding them together with the use of a weak binder are disposed in the abrading plate, the fine abrasive particles can easily show a self-producing effect during polishing. Thus, stability of the polishing speed against the fine pattern on the semiconductor wafer can be increased, and occurrence of scratches (flaws) can be prevented.

The abrasive particles or the abrasive particle aggregates may be enclosed in capsules. For example, the abrasive particles with a large particle size and the abrasive particles with a small particle size are enclosed differently in two type of capsules, and disposed in the abrading plate, whereby the two types of capsules can be put to different uses. If a higher polishing speed is needed, the abrasive particles are released only from the capsules containing the larger abrasive particles, so that the abrasive particles with the large particle size can be applied for self-producing to the surface to be polished. If a fine pattern needs to be polished away, the abrasive particles are released from the capsules containing the smaller abrasive particles, so that the abrasive particles with the small particle size can be fed to the surface to be polished.

The chemical may be enclosed in capsules. By so doing, a liquid chemical can be placed in the abrading plate. Thus, a liquid surface-active agent, for example, can be enclosed in the abrading plate, and a liquid oxidizing agent or reducing agent can also be enclosed in the abrading plate. The enclosure of the surface-active agent provides the self-stop function, as stated earlier. Alternatively, the enclosure of an aqueous solution of hydrogen peroxide ($H_2O_2$) in capsules leads to release of the aqueous solution of hydrogen peroxide during polishing, thereby making it possible to oxidize, for example, a metallic film to be polished, while performing polishing similar to chemical and mechanical polishing, together with polishing using abrasive particles.

The abrading plate may contain plural types of capsules, and the plural types of capsules may have inclusions of different compositions. Since the capsules have the inclusions of different compositions, it becomes possible to combine these inclusions, thereby showing various effects. For example, the placement of capsules containing a surface active agent and capsules containing a dispersant in the abrading plate enables the surface active agent and the dispersant released from the two types of capsules to act effectively in harmony during polishing, thus permitting the surface active agent to function.

The capsules may be such that plural types of substances are enclosed in single capsules.

A second aspect of the invention is a method for polishing a substrate with the use of the abrading plate for polishing as recited above, wherein the abrasive particles and the chemical are released from the abrading plate mainly by dressing during polishing process. Simultaneously with or prior to polishing of the object to be polished with the use of the abrading plate, dressing of the abrading plate is performed, whereby the abrasive particles and the chemical can be supplied in abundance to the surface to be polished. Consequently, stability of the polishing speed during polishing with the abrading plate, and the step characteristics can be enhanced. Furthermore, the self-stop function, the oxidizing function, etc. of the aforementioned chemicals can be shown effectively.

The above and other objects, features, and advantages of the present invention will be apparent from the following description when taken in conjunction with the accompanying drawings which illustrates preferred embodiments of the present invention by way of example.

## BRIEF DESCRIPTION OF THE DRAWINGS

FIG. 1 is a view schematically showing a structural example of an abrading plate according to an embodiment of

the invention;

FIG. 2 is a view illustrating a spray dryer;

FIGS. 3A to 3G are views illustrating a method for producing the abrading plate of the present invention;

FIG. 4 is a view schematically showing a structural example of an abrading plate according to another embodiment of the invention;

FIG. 5 is a view schematically showing a structural example of an abrading plate according to still another embodiment of the invention;

FIGS. 6A and 6B are each a view schematically showing a structural example of an abrading plate according to a further embodiment of the invention; and

FIGS. 7A and 7B are each a view schematically showing a structural example of an abrading plate according to a still further embodiment of the invention.

## DETAILED DESCRIPTION OF THE PREFERRED EMBODIMENTS

Preferred embodiments of the present invention will now be described in detail with reference to the accompanying drawings.

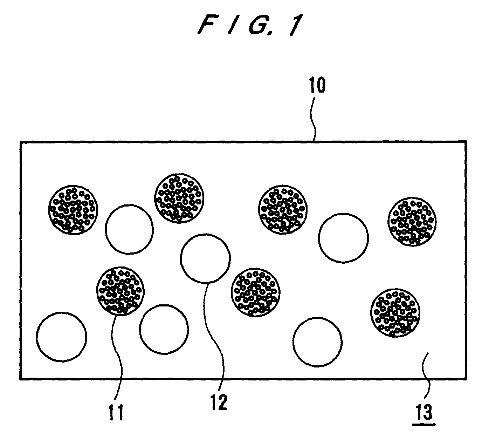

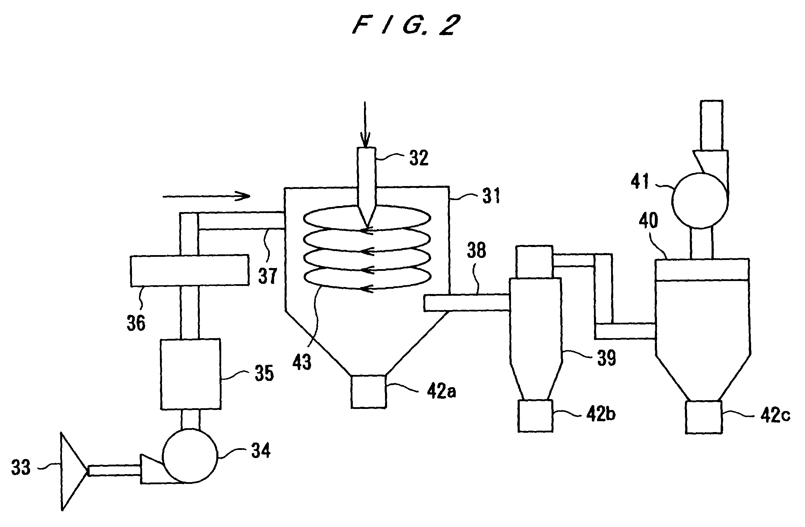

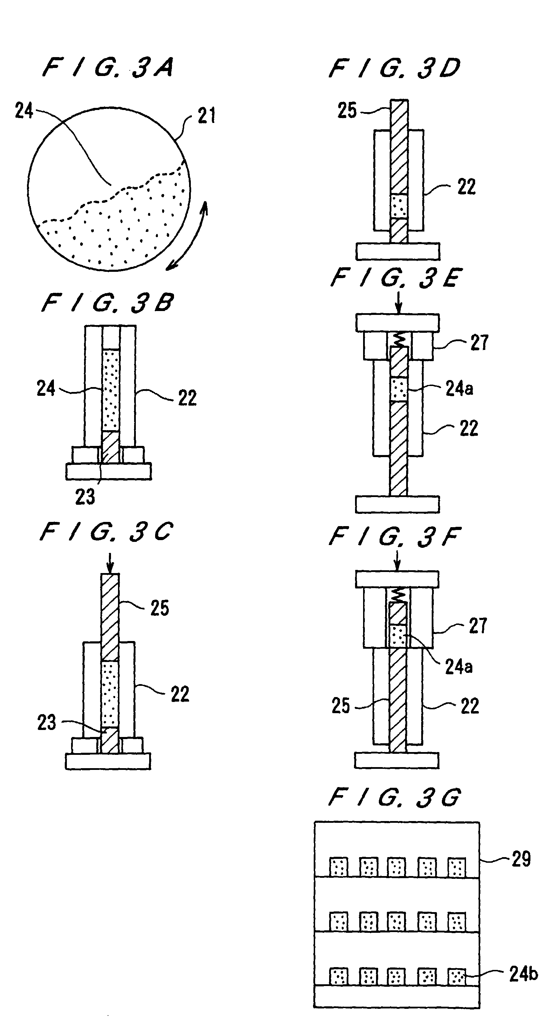

FIG. 1 schematically shows the composition of an abrading plate according to an embodiment of the invention. An abrading plate 10 is composed of aggregates 11 of abrasive particles, capsules 12 enclosing a surface-active agent, and a binder 13, such as phenol resin, which has bound the aggregates 11 and the capsules 12 together. Pores, which are tiny voids, are present among the abrasive particle aggregates 11 and capsules 12 and the binder 13, or in the binder 13, although these are not shown. The fine abrasive particle aggregates 11 are lumpy gatherings of many fine abrasive particles having a diameter of, for example, about 0.35 $\mu$m which have been granulated to diameters of 5 to 100 $\mu$m. In actuality, spherical aggregates of about 20 to 50 $\mu$m in diameter are easy to produce.

The material for the fine abrasive particles is cerium oxide ($CeO_2$), alumina ($Al_2O_3$), silicon carbide (SiC), silicone oxide ($SiO_2$), zirconia (ZrO), iron oxide (Feo, $Fe_3O_4$), manganese oxide ($MnO_2$, $Mn_2O_3$), maganesium oxide (MgO), calcium oxide (CaO), barium oxide (BaO), zinc oxide (ZnO), barium carbonate ($BaCO_3$), diamond (C) or the like. These fine abrasive particles are formed into lumps or aggregates via a weak binder such as ethyl cellulose. Placement of such lumped fine abrasive particles in an abrading plate makes it possible to supply a large amount of fine abrasive particles during polishing to a surface to be polished, thereby decreasing scratches. Since the large amount of abrasive particles can be supplied to the surface to be polished, stability of the polishing speed can be enhanced, the step characteristics can be improved, and the pattern dependency can be eliminated.

The amount of flaws (scratches) occurring during polishing is closely related to the size of abrasive particles. To decrease this amount, the use of fine abrasive particles is necessary. A conventional method for producing a common abrading plate by bonding abrasive particles with a binder has required a uniform bonding force among fine abrasive particles in order to fix the abrasive particles and obtain stable polishing performance. For this purpose, the fine abrasive particles need to be uniformly dispersed and bound together by a binder.

However, because of the small size of the particles, their surface area becomes larger compared with their volume, then it tends to aggregate with each other by the influence of their larger surface area. Further, once the fine abrasive particles are aggregated, these are fixed strongly with each other thus difficult to re-disperse with each other. Thereby, the abrasive particles of fine sizes are hard to store them in powder state, but it is desirable to store them in a dissolved state in a solution. In a dissolved state in a solution called "slurry", the fine abrasive particles are easily dispersed with each other by addition of a small amount of surface-active agent. Therefore the fine abrasive particles are easily stored in the solution without aggregation.

In order to fix the fine abrasive particles in an abrading plate, it is difficult to fix the abrasive particles in the slurry directly to the abrading plate, and it is required to be powdered by drying the slurry. However, when the slurry is dried as it is, the before-mentioned aggregation of abrasive particles occur thus leading difficult to disperse the abrasive particles again from the aggregation. In accordance with a situation of the surface state of the abrasive particles, the powder may allow to disperse the abrasive particles easily. However in such a state, it is difficult to fabricate an abrading plate from the abrasive particles, because air exists around the abrasive particles thus increasing a volume of the powder per its unit weight, deteriorating outgassing characteristics, and causing powder friction. Further, since the fine abrasive particle has its larger surface area and is easily bonded to the binder with strong force, the used abrasive particles remain at the abrasive surface of the abrading plate when the fine abrasive particles are fixed in the abrading plate. Thus, it is not enough to supply unused (fresh) abrasive particles, which is effective for polishing, on the abrasive surface of the abrading plate. Namely, it is difficult to supply self-producing abrasive particles effectively thereon. Thus, fine abrasive particles are effective for polishing away a fine pattern. However, the self-producing of the abrasive particles is difficult, and the polishing speed decreases.

The use of a binder with a low bonding force permits an abrading plate to be constituted from fine abrasive particles, which has a certain polishing speed. In this case, the resulting abrading plate is so brittle that the step characteristics and the stability of the polishing speed are questionable. As shown in FIG. 1, therefore, it is preferred to granulate fine abrasive particles into clusters (fine abrasive particle aggregates), which measure about several micrometers to several tens of micrometers, by use of weak bonds, and then mold the clusters into an abrading plate with the use of an ordinary binder. This makes the cluster (fine abrasive particle aggregate) roll as if an abrasive particle of large size. Therefore, it provides easy handling means for fine abrading particles and reduces the problem of outgassing characteristics and powder friction when the abrading plate is formed, thus providing easy formation method of the abrading plate having fine abrasive particles. Further it allows to make the abrading plate having certain strength and to supply free abrasive particles easily, thus supplying a large amount of fine abrasive particles to the surface to be polished. As abrasive particles become finer to an average particle size of 0.2 $\mu$m or less, they undergo agglomeration, which fix the abrasive particles strongly with each other thus making it difficult to disperse. As noted from this, it is difficult to store finer abrasive particles as they are. However the pattern width of a semiconductor device becomes finer, polishing with even finer abrasive particles is required. In fixing such fine abrasive particles to an abrading plate, the use of the aforementioned fine abrasive particle aggregates may be very effective. Through the use of such fine abrasive particle aggregates, the self-producing action of abrasive particles during polishing takes place. Under this action, the abrasive particles tend to shave the abrading plate surface, exposing fresh abrasive particles on the surface being polished. These fresh abrasive particles in turn produce a self-producing effect. This chain of actions permits polishing free from loading of the abrading plate and causing few flaws (scratches) during polishing operation. Besides, sharp cutting characteristics persist, and high polishing performance is obtained.

To constitute such fine abrasive particle aggregates, fine abrasive particles should desirably be bonded together with the use of a binder having a weak bonding force. As water-soluble binders, sweet potatoes, starch, potato starch, cornstarch, dextrin, and sodium alginate are available. Any of these materials, when supplied with water or hot water during polishing, has its bonding force weakened, releasing the fine abrasive particles. Other binders, such as acacia, gelatin, CMC (sodium carboxymethyl cellulose), Met Hocel (methyl cellulose), and partially saponified PVA (polyvinyl alcohol), have their bonding force weakened by water or hot water. Binders, such as PVP (polyvinyl pyrrolidone), HPMC (hydroxy propyl methyl cellulose), HPC (hydroxy propyl cellulose), and PEG (macrogol), have the effect of weakening in bonding force in the presence of alcohol as well as water. Abrasive particle aggregates are formed by spray drier method as mentioned in the following, water may be used as a binder. In such case, abrasive particle aggregates can be well formed by using only water as a binder. Farther, organic solvent such as ethanol or IPA is also effective.

As fine abrasive particle aggregates are constituted by using a binder having a weak bonding force such as water, organic dissolvent and dextrin, and the fine abrasive particle aggregates are fixed in an abrading plate, it provides self-producing of fine abrasive particles easily when the abrading plate is used for polishing. Accordingly the stability of polishing speed can be increased for polishing fine patterns of semiconductor device, and flaws or scratches can be prevented. Further, the places where fine abrasive particle aggregates have been fixed in the abrading plate become voids like pockets, which are fairly larger than the sizes of usual abrasive particles, when the aggregates are gone. Foreign matters such as garbage and large size particles for retarding miller polishing which are rarely produced during polishing operation are trapped in the voids thus preventing scratches on the wafer effectively.

The fine abrasive particle aggregates can be encapsulated in the wrapping body, thus enabling control of solubility and emission of abrasive particles. When ultra fine abrasive particles used, once the abrasive particles are dried, it is difficult to disperse again. Therefore it is preferable to encapsulate the dissolved solution of ultra fine abrasive particles into a capsule as it is in the perfectly dispersed state in the solution. Accordingly, perfectly dispersed ultra fine abrasive particles are supplied during polishing operation. Since the supplied abrasive particles are not aggregated, then the effect of ultra fine abrasive particles is fully exerted for polishing finer patterns. In this case of encapsulation, effects of easy formation of abrading plate and voids or pockets for trapping foreign matters are exerted same as it is described before. Further, chemical solution also can be encapsulated into the capsule adding to the slurry of abrasive particles.

Next, encapsulation of the chemical will be described. The capsule 12 shown in FIG. 1 has, for example, a surface-active agent enclosed therein, as stated earlier. By the encapsulation of the chemical, the chemical can not be deteriorated or reacted until it performs its role effectively contributing to the polishing. In the conventional technology, the chemical or polishing solution is supplied from outside through holes or grooves formed in the abrading plate. According to the capsule enclosing chemical, it is not required to equip holes or grooves, but also it enables to produce chemical all over the wafer to be polished uniformly. Further, when fine or ultra fine abrasive particles and the chemical are enclosed in same capsules or respective capsules, the abrasive particles are well dispersed thus providing stable polishing reaction.

An example of the surface-active agent is a substance having both a hydrophilic atomic group and a hydrophobic atomic group in the molecule. As the surface active agent, for example, special carboxylic acid type high molecular surface active agents, and metal free type surface active agents having their sodium salts substituted by ammonium salts are usable. The size of the microcapsule 12 having the chemical enclosed therein is, for example, about several tens of micrometers, and an aqueous solution of hydrogen peroxide may be used as the chemical. Since an aqueous solution of hydrogen peroxide has an oxidizing action, it may be combined with alumina abrasive particles for polishing of copper (Cu), for example. In this case, mechanical polishing with the abrasive particles can proceed while oxidizing the surface of the copper. Also, capsules of a surface-active agent may be added along with capsules of an aqueous solution of hydrogen peroxide. By this measure, the surface-active agent can be utilized as a dispersing agent.

Further, glycin(amino acid) or quinaldinic acid can be effectively employed as chemical for polishing. It is known that glycin (organic acid) is reacted with hydrate of cupper and forms water soluble chelate complex of four coordination.

$$Cu(H_2O)_4{}^2+2NH_2CHOOH \rightarrow Cu(NH_2CH_2COOH)_2+4H_2O+2H^+$$

Therefore while polishing cupper, ion concentration of cupper is not being saturated and kept constant, thus proceeding stable polishing.

The capsules may contain a solution of an alkali, such as KOH, enclosed therein. Generally, chemical and mechanical polishing (CMP) using a polishing slurry often employ an alkali solution as a solution for forming the slurry, and the encapsulation of an alkali solution can supply the alkali solution to the surface to be polished from within the abrading plate. Hence, this encapsulation polishing method, although using only the abrading plate and pure water, can perform CMP upon the same principle as that using polishing slurry.

Alternatively, polishing auxiliaries, such as dispersants, rate stabilizers, bond solubilizers, machinability promoters, and mirror surface improvers, may be enclosed in capsules. Here, bond solubilizer is one of chemical element of the fixed abrasive plate, and is able to soften or dissolve the resin material. Amount of addition thereof may control the amount of self-producing abrasive particles of the abrading plate. Also, it is possible that refreshing of abrading surface of the abrading plate by dressing is not required.

The above explanation refers to examples of encapsulation of the chemical that is a liquid. If the chemical is a solid, its enclosure in capsules is not necessarily required, but it may be fixed directly inside an abrading plate. For example, if a solid surface-active agent is used, it can be directly placed inside the abrading plate without the use of capsules. The same is true of the polishing auxiliaries, as well as the oxidizing agents and reducing agents. When these oxidizing or reducing agents are supplied to the surface to be polished, they cause an oxidizing action or reducing action upon reaction with water.

As methods for enclosing the chemical in capsules, various publicly known microencapsulation technologies can be used. Chemical methods include interfacial polymerization and in situ polymerization. Physical methods include phase separation, and interfacial precipitation. Physicomechanical methods include spray drying, and air suspension coating. For example, a triple nozzle of a concentric configuration is prepared to eject from the internal nozzle a substance to be enclosed in a capsule, eject from the intermediate nozzle a protective layer substance, and eject from the external nozzle a coating solution as a jet. The jet ejected from the nozzle wraps the substance, as the object to be encapsulated, inside by the action of surface tension, and forms outwardly a spherical droplet of the coating solution. This droplet gradually cools while falling, and solidifies on its external side. As a result, a capsule is produced, with a solid coating layer formed outside, and the liquid enclosed inside.

The spray drying method comprises, as follows. Fine abrasive particles are diffused in a solution, and dispersed thoroughly by application of, for example, ultrasonic waves to form a suspension of the fine particles. The suspension of the fine particles is supplied into a space where hot air is whirling spirally. As a result, a liquid portion of the suspension is instantaneously dried, whereupon the fine particles form aggregates while increasing a surface area per unit volume. When abrasive particles of about 0.3 μm in diameter as stated previously are used as the fine particles, they can be formed into spherical aggregates of the fine abrasive particles, the aggregates measuring about 5 to 100 μm in diameter. According to this spray drying method, numerous steps, such as concentration, filtration, pulverization, classification, and drying, can be performed instantaneously at a stroke, whereby lumpy aggregates can be formed easily from the fine particles. The spray drying method can be applied not only to granulation of fine abrasive particles, but enclosure of fine abrasive particles in capsules, and encapsulation of a chemical can be performed according to the same principle as spray drying.

FIG. 2 shows an example of a spray dryer preferred for granulation by the above-described spray drying method. Hot air is blown into a spray dryer body 31 through piping 37, whereby a spiral stream 43 is formed in the body 31. Air is fed by a blower 34 via an air filter 33, and heated with a heater 35 to make hot air, which is supplied via a filter 36 into the body 31. A fine granulator 32 supplies a suspension of fine abrasive particles into hot air, which is whirling spirally, thereby forming abrasive particle aggregates as stated earlier. The resulting abrasive particle aggregates enter a container 42a disposed below the body 31, or is screened by a cyclone 39 via piping 38, and then admitted into a chamber 42b located underneath. Alternatively, the aggregates are screened by a bag filter 40, and enter a chamber 42c located underneath. The hot air that has passed through the bag filter 40 is discharged by an exhauster 41.

In addition to encapsulation of a surface-active agent, it is effective to encapsulate other polishing auxiliaries such as buffers or amines and make such capsules coexist. There are substances, which if premixed will proceed with reaction and show minimal effect, but which if mixed immediately before polishing will be able to take effect very effectively. Encapsulation of such substances will enable the chemical to be released during polishing, and to be mixed while polishing is performed. Thus, the effect of the chemical can be shown effectively. For example, an aqueous solution of hydrogen peroxide and alumina particles are mixed immediately before polishing of copper, whereby an increase in the polishing speed can be achieved.

Next, self-producing of abrasive particles and release of a chemical by dressing will be described. Polishing with a hard abrading plate generally improves the step characteristics, and after dressing, has a high polishing speed, but thereafter the polishing speed tends to lower. As noted from these facts, stability of the polishing speed is problematical. If self-producing abrasive particles can be supplied abundantly to the surface to be polished with the use of a hard abrading plate, stability of the polishing speed can be improved, and pattern dependency can be eliminated. For this abundant supply of self-producing abrasive particles to the surface to be polished, dressing of the abrading plate surface is important. In particular, so-called in situ dressing, performed together with polishing, is effective. A method of dressing may be by a diamond dresser, which has hitherto been used for dressing of an abrasive cloth or a polishing pad. Alternatively, the application of heat (hot air blow or irradiation of infrared light modifies the surface state of the resin to be deteriorated or changed), light (short wavelength light such as ultra violet light modifies the surface state of the resin to be deteriorated or changed), ultrasonic waves, or an electric current to the abrading plate surface weakens or cuts off the bond imparted by the binder on the surface of the abrading plate, whereby the abrasive particles or chemical fixed in the abrading plate can be released.

With an ordinary abrading plate, if self-producing abrasive particles exist in large amounts on the surface to be polished, the polishing speed increases. This causes a failure in showing the self-stop function that when projections are shaved off and a flat surface is obtained, progress of polishing stops. With the abrading plate of the present invention, on the other hand, the supply of a surface-active agent allows the self-stop function to show up, in addition to achieving stability of the polishing speed. Dressing can not only result in self-producing of abrasive particles, but also supply the surface to be polished with a surface active agent enclosed in capsules, or a surface active agent disposed in a solid condition (without capsules) in the abrading plate. Not only the surface-active agent, but also other chemicals necessary for polishing can be similarly fed by dressing to show their respective merits.

Next, a method for producing the abrading plate will be described. As illustrated in FIG. 3A, materials for an abrading plate, which comprise abrasive particles, a chemical, and a binder, are charged into a drum container 21, which is turning, to mix the materials thoroughly. On this occasion, the abrasive particles may be ordinary abrasive particles, or lumpy abrasive particle aggregates of fine abrasive particles granulated by a spray dryer. The chemical may be a solid particulate chemical, or an encapsulated chemical. The mixing of the abrading plate materials need not be performed by a rotary drum, but may be carried out by a suitable mixing method such as an agitator. Then, as shown in FIG. 3B, a powdery mixture of the abrasive particles, chemical and binder is weighed, and a mixed powder 24 is put into a container formed from a die 22 and a punch 23. At this stage, vacuum venting is performed. Vacuum venting can reduce the content of air in the mixed powder, and provide an appropriate porosity (void ratio). That is, vacuum venting obtains an appropriate porosity without imposing a strong pressure, thus preventing breakage of capsules.

Then, as shown in FIG. 3C, an upper punch 25 is set, and after pressurization at a pressure of about 3 kgf/cm$^2$, the pressure is released once. Then, as shown in FIG. 3D, a die receiver 26 is detached, and the mixed powder 24 is pressurized up to a predetermined pressure for compression molding. Then, as shown in FIG. 3E, the system is turned upside down, and with a preload being imposed on a molded product 24a by a spring, the die 22 is pressed by use of a spacer 27. Further, as shown in FIG. 3F, the molded product 24a is withdrawn, with the spacer 27 being replaced so that the spring above the punch will work effectively when the die 22 is pushed out. Such withdrawal of the molded product with the spring acting is intended to prevent cracking of the resulting abrading plate, etc.

Finally, as shown in FIG. 3G, the withdrawn molded product 24a is placed in a vacuum oven. When a phenol resin, for example, is used as the binder, the molded product 24a is fired at about 180°C, the curing temperature of the phenol resin. Then, the inside of the furnace is slowly cooled, and the resulting abrading plate 24b is taken out. According to this process, as noted above, vacuum venting is carried out to remove air from inside the mixed powder, hereafter the mixed powder is compression molded. Thus, compression molding at a relatively low pressure becomes possible. Consequently, breakage of capsules can be prevented, and the abrading plate containing the chemical can be produced. The vacuum venting may be performed by providing a vacuum exhaust port in the molding container, and evacuating air under vacuum through the vacuum exhaust port. Alternatively, the vacuum venting may be carried out by housing the molding container itself in a vacuum container, and evacuating air from the entire vacuum container while pressure is given for molding the mixed powder under vacuum.

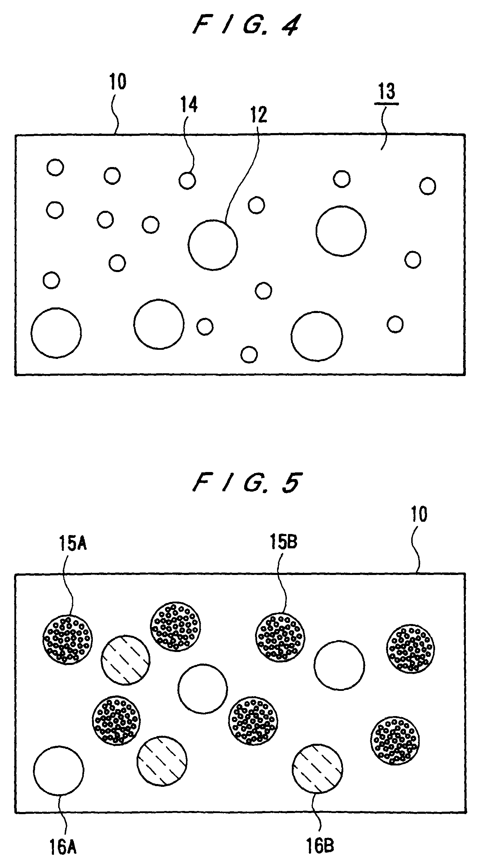

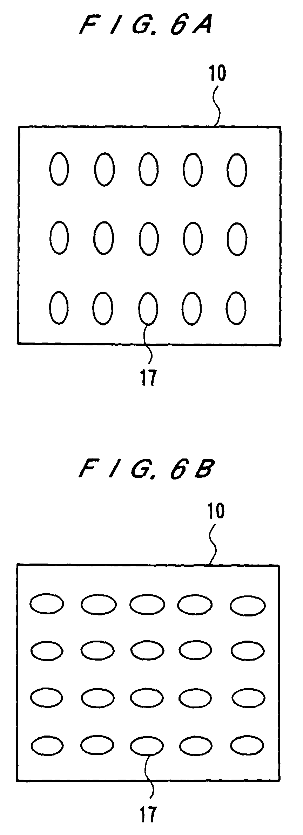

FIGS. 4 and 5 are views showing other structural examples of the abrading plate of the present invention having abrasive particles and a chemical fixed therein. FIG. 4 shows an abrading plate comprising ordinary abrasive particles bound together by a binder, and having a chemical further fixed to the abrading plate. A chemical 12 is a surface-active agent, an oxidizing or reducing agent, or a polishing auxiliary. As the chemical 12, a solid chemical may be fixed unchanged in the abrading plate, or a liquid chemical may be enclosed in capsule and fixed in the abrading plate. The chemical 12 is placed in an ordinary abrading plate, for example, composed of abrasive particles 14 comprising cerium oxide and a binder 13 such as phenol resin, and pure water is used as a lubricant or a coolant during polishing, whereby chemical and mechanical polishing can be performed without the use of other chemicals. By using a surface-active agent as the chemical, moreover, the self-stop function can be exhibited.

FIG. 5 shows an example of using two types of abrasive capsules 15A and 15B, and two types of chemical capsules 16A and 16B. In the abrasive particle capsule 15A, abrasive particles A suitable for polishing of, for example, an oxide film are enclosed. In the chemical capsule 16A, a chemical A used in combination with the abrasive particles A is enclosed. In the abrasive particle capsule 15B, abrasive particles B suitable for polishing of, for example, a metal film are enclosed. In the chemical capsule 16B, a chemical B used in combination with the abrasive particles B is enclosed. The abrasive particle capsule 15A and the chemical capsule 16A are ruptured, for example, in the presence of a liquid with a high pH to release their contents. The abrasive particle capsule 15B and the chemical capsule 16B are ruptured, for example, in the presence of a liquid with a low pH to release their contents. According to such abrading plate, the abrasive particles and chemical solution are supplied from capsules adapted for the pH of the liquid fed as the lubricant and coolant during polishing. Thus, a single abrading plate can selectively supply the abrasive particles and chemical solution suitable for a plurality of uses, for example, use for an oxide film and use for a metal film.

FIGS. 6A and 6B show another embodiment of the invention. An abrading plate 10 has capsules 17 fixed therein, each capsule 17 containing a mixture of abrasive particles, a chemical and a polishing auxiliary. In encapsulating these materials, the capsule may be in a spherical shape, or an ellipsoid of revolution (i.e. spheroid) as illustrated. In the case of a spheroid, spheroids 17 may be placed such that the long side of the spheroid is perpendicular to the surface to be polished as shown in FIG. 4A, or such that the short side of the spheroid is perpendicular to the surface to be polished as shown in FIG. 4B. By positioning the long side of the spheroid perpendicularly to the surface to be polished as shown in FIG. 4A, the contents of the capsule 17 consisting of the abrasive particles, chemical and polishing auxiliary can be slowly supplied to the surface to be polished. By positioning the short side of the spheroid 17 perpendicularly to the surface to be polished as shown in FIG. 4B, the contents of the capsule consisting of the abrasive particles, chemical and polishing auxiliary can be rapidly supplied to the surface to be polished.

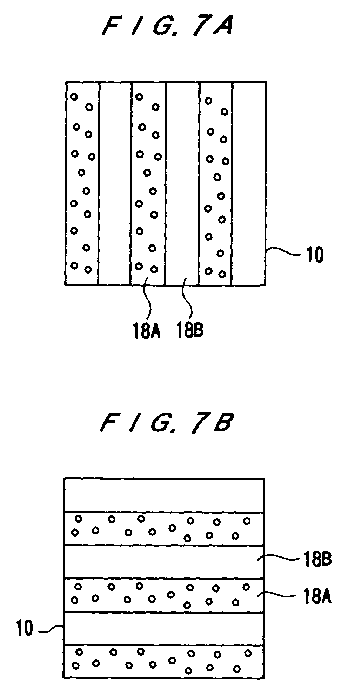

FIGS. 7A and 7B show an abrading plate according to still another embodiment of the invention. This abrading plate comprises layers 18A and layers 18B arranged alternately in a sheet-like configuration, the layer 18A having abrasive particles fixed therein, and the layer 18B having a chemical and a polishing auxiliary fixed therein. The layer 18A having the abrasive particles placed therein may comprise ordinary abrasive particles, such as cerium oxide or alumina, fixed with a binder such as phenol resin, or may comprise fine abrasive particle aggregates granulated in lumpy form from fine abrasive particles as stated earlier. The layer 18B having the chemical and polishing auxiliary placed therein may comprise a solid chemical and a solid polishing auxiliary fixed similarly with a binder such as phenol resin, or may be a layer formed by enclosing a liquid chemical and a liquid polishing auxiliary in capsules, and fixing these capsules with a binder. As shown in FIG. 7A, when the sheet-like layers 18A and 18B are placed perpendicularly to the surface to be polished, the abrasive particles, chemical and polishing auxiliary can be supplied uniformly from the respective layers to the surface to be polished with the progress of polishing, and these materials mix to carry out polishing. When the abrasive particle layers 18A and the chemical/polishing auxiliary layers 18B are parallel to the surface to be polished as shown in FIG. 7B, the abrasive particles, and the chemical/polishing auxiliary are sequentially supplied to the surface to be polished as polishing proceeds.

Although certain preferred embodiments of the present invention have been shown and described in detail, it should be understood that various changes and modifications may be made therein without departing from the scope of the appended claims.

## Claims

1. A fixed abrasive polishing tool comprising:

   abrasive particles;
   a chemical; and
   a binder for binding the abrasive particles and the chemical together.

2. A fixed abrasive polishing tool as claimed in claim 1, wherein the abrasive particles form abrasive particle aggregates.

3. A fixed abrasive polishing tool as claimed in claim 1, wherein the abrasive particles are enclosed in capsules.

4. A fixed abrasive polishing tool as claimed in claim 2, wherein the abrasive particle aggregates are enclosed in capsules.

**5.** A fixed abrasive polishing tool as claimed in claim 1, wherein the chemical is enclosed in capsules.

**6.** A fixed abrasive polishing tool as claimed in claim 1, wherein the fixed abrasive polishing tool contains at least a kind of capsules, in which at least one of the chemical and the abrasive particles is enclosed.

**7.** A fixed abrasive polishing tool as claimed in claim 6, wherein the fixed abrasive polishing tool contains a kind of capsules, in which plural types of substances are enclosed.

**8.** A fixed abrasive polishing tool as claimed in claim 6, wherein the fixed abrasive polishing tool contains plural types of capsules, in which plural types of substances are enclosed.

**9.** A method for polishing a substrate with use of the fixed abrasive polishing tool, said fixed abrasive polishing tool having:

abrasive particles;
a chemical; and
a binder for binding the abrasive particles and the chemical together,
wherein the abrasive particles and the chemical are supplied on an abrasive surface of the fixed abrasive polishing tool together during or before polishing process.

**10.** A method as claimed in claim 9, wherein the abrasive particles and the chemical are released from the fixed abrasive polishing tool mainly by dressing during or before polishing process.

**11.** A method as claimed in claim 9, wherein the abrasive particles are released from abrasive particle aggregates fixed in the fixed abrasive polishing tool.

**12.** A method as claimed in claim 9, wherein the chemical is supplied from capsules fixed in the fixed abrasive polishing tool.

**13.** A method as claimed in claim 9, wherein the chemical is surface active agent.

## F I G. 1

10

11    12    13

FIG. 2

EP 1 078 717 A2

F I G. 3 A

24

21

F I G. 3 D

25

22

F I G. 3 B

24

22

23

F I G. 3 E

27

24a

22

F I G. 3 C

25

22

23

F I G. 3 F

27

24a

25

22

F I G. 3 G

29

24b

## F I G. 4

## F I G. 5

F I G. 6A

10

17

F I G. 6B

10

17

## F I G. 7A

10

18A  18B

## F I G. 7B

18B

18A

10